# EUROPÄISCHE PATENTANMELDUNG

(11) **EP 2 408 260 A1**
(43) Veröffentlichungstag der Anmeldung: **18.01.2012**
(21) Anmeldenummer: 10169372.9
(22) Anmeldetag: 13.07.2010
(51) Int. Cl.: H05B 3/84, H01R 13/20, H01R 13/11

(54) **Glasscheibe mit einem elektrischen Anschlusselement**

(71) Anmelder: Saint-Gobain Glass France, 92400 Courbevoie (FR)
(72) Erfinder: Cholewa, Harald, 52064 Aachen (DE); Lesmeister, Lothar, 6373 Landgraaf (NL); Reul, Bernhard, 52134 Herzogenrath (DE); Rateiczak, Mitja, 52146 Würselen (DE); Schlarb, Andreas, 52134 Herzogenrath (DE); Schmidt, Lothar, 52074 Aachen (DE)
(74) Vertreter: Lendvai, Tomas

(57) **Zusammenfassung**

Die vorliegende Erfindung betrifft eine Scheibe mit einem elektrischen Anschlusselement, umfassend:
- ein Substrat aus Glas (1),
- eine elektrisch leitfähige Struktur (2) mit einer Schichtdicke von 5 µm bis 40 µm auf einem Bereich des Substrats (1),
- ein Anschlusselement (3) und
- eine Schicht einer Lotmasse (4), die das Anschlusselement (3) mit einem Teilbereich (12) der elektrisch leitfähigen Struktur (2) elektrisch verbindet, wobei
- das Anschlusselement (3) zumindest eine Eisen-Nickel-Legierung oder eine Eisen-Nickel-Kobalt-Legierung enthält,
- das Anschlusselement (3) über eine Kontaktfläche (11) vollflächig mit dem Teilbereich (12) der elektrisch leitfähigen Struktur (2) verbunden ist und
- die Kontaktfläche (11) keine Ecken aufweist.

## Beschreibung

Die Erfindung betrifft eine Scheibe mit einem elektrischen Anschlusselement und ein wirtschaftliches und umweltfreundliches Verfahren zu deren Herstellung.

Die Erfindung betrifft weiter eine Scheibe mit einem elektrischen Anschlusselement für Fahrzeuge mit elektrisch leitfähigen Strukturen wie beispielsweise Heizleiter oder Antennenleiter. Die elektrisch leitfähigen Strukturen sind üblicherweise über angelötete elektrische Anschlusselemente mit der Bordelektrik verbunden. Aufgrund unterschiedlicher thermischer Ausdehnungskoeffizienten der verwendeten Materialien treten mechanische Spannungen bei der Herstellung und im Betrieb auf, welche die Scheiben belasten und den Bruch der Scheibe hervorrufen können.

Bleihaltige Lote weisen eine hohe Duktilität auf, die auftretende mechanische Spannungen zwischen elektrischem Anschlusselement und der Scheibe durch plastische Deformierung kompensieren können. Allerdings müssen aufgrund der Altauto-Richtlinie 2000/53/EG innerhalb der EG bleihaltige Lote durch bleifreie Lote ersetzt werden. Die Richtlinie wird zusammenfassend mit dem Kürzel ELV (End of life vehicles) bezeichnet. Das Ziel ist dabei, im Zuge der massiven Ausweitung von Wegwerfelektronik äußerst problematische Bestandteile aus den Produkten zu verbannen. Die betroffen Substanzen sind Blei, Quecksilber, Cadmium und Chrom. Das betrifft unter anderem die Durchsetzung von bleifreien Lötmitteln in elektrischen Anwendungen auf Glas und die Einführung entsprechender Ersatzprodukte hierzu.

EP 1 942 703 A2 offenbart ein elektrisches Anschlusselement an Scheiben von Fahrzeugen, wobei die Differenz der thermischen Ausdehnungskoeffizienten von Scheibe und elektrischem Anschlusselement < 5 x 10-⁶/°C beträgt. Um eine ausreichende mechanische Stabilität und Prozessierbarkeit zu ermöglichen wird vorgeschlagen einen Lotmassenüberschuss zu verwenden. Der Überschuss an Lotmasse tritt aus dem Zwischenraum zwischen Anschlusselement und elektrisch leitfähiger Struktur heraus. Der Überschuss an Lotmasse verursacht hohe mechanische Spannungen in der Glasscheibe. Diese mechanischen Spannungen führen schließlich zum Bruch der Scheibe.

Die Aufgabe der vorliegenden Erfindung ist es, eine Scheibe mit einem elektrischen Anschlusselement und ein wirtschaftliches und umweltfreundliches Verfahren zu deren Herstellung bereitzustellen, wobei kritische mechanische Spannungen in der Scheibe vermieden werden.

Die Aufgabe der vorliegenden Erfindung wird durch eine Scheibe mit einem Anschlusselement gelöst, das die folgende Merkmale umfasst:
- ein Substrat aus Glas,
- eine elektrisch leitfähige Struktur mit einer Schichtdicke von 5 µm bis 40 µm auf einem Bereich des Substrats,
- ein Anschlusselement und
- eine Schicht einer Lotmasse, die das Anschlusselement mit einem Teilbereich der elektrisch leitfähigen Struktur elektrisch verbindet, wobei
- das Anschlusselement zumindest eine Eisen-Nickel-Legierung oder eine Eisen-Nickel-Kobalt-Legierung enthält,
- das Anschlusselement über eine Kontaktfläche vollflächig mit dem Teilbereich der elektrisch leitfähigen Struktur verbunden ist und
- die Kontaktfläche keine Ecken aufweist.

Auf der Scheibe ist eine elektrisch leitfähige Struktur aufgebracht. Ein elektrisches Anschlusselement ist mit einer Lotmasse auf Teilbereichen mit der elektrisch leitfähigen Struktur elektrisch verbunden. Die Lotmasse tritt bevorzugt mit einer Austrittsbreite von < 1 mm aus dem Zwischenraum zwischen dem Anschlusselement und der elektrisch leitfähigen Struktur aus.

In einer bevorzugten Ausgestaltung ist die maximale Austrittsbreite kleiner 0,5 mm und insbesondere etwa 0 mm. Die maximale Austrittsbreite kann auch negativ sein, also in den von elektrischem Anschlusselement und elektrisch leitfähiger Struktur gebildeten Zwischenraum zurückgezogen sein, bevorzugt in einem konkaven Meniskus.

Die maximale Austrittsbreite ist definiert als der Abstand zwischen den Außenkanten des Anschlusselementes und der Stelle des Lotmasseübertritts, an dem die Lotmasse eine Schichtdicke von 50 µm unterschreitet.

Der Vorteil liegt in der Reduzierung der mechanischen Spannungen in der Scheibe, insbesondere im kritischen Bereich der bei einem großen Lotmasseübertritt vorliegt.

Der erste thermische Ausdehnungskoeffizient ist bevorzugt von 8 x 10⁻⁶/°C bis 9 x 10⁻⁶/°C. Das Substrat ist bevorzugt Glas, das bevorzugt einen thermischen Ausdehnungskoeffizienten von 8,3 x 10⁻⁶/°C bis 9 x 10⁻⁶/°C in einem Temperaturbereich von 0 °C bis 300 °C aufweist.

Der zweite thermische Ausdehnungskoeffizient ist bevorzugt von 8 x 10⁻⁶/°C bis 9 x 10⁻⁶/°C, besonders bevorzugt von 8,3 x 10⁻⁶/°C bis 9 x 10⁻⁶/°C in einem Temperaturbereich von 0 °C bis 300 °C.

Der thermische Ausdehnungskoeffizient des Anschlusselements kann ≤ 4 x 10⁻⁶/°C betragen.

Die erfindungsgemäße elektrisch leitfähige Struktur weist bevorzugt eine Schichtdicke von 8 µm bis 15 µm, besonders bevorzugt von 10 µm bis 12 µm auf. Die erfindungsgemäße elektrisch leitfähige Struktur enthält bevorzugt Silber, besonders bevorzugt Silberpartikel und Glasfritten.

Die erfindungsgemäße Schichtdicke des Lots ist bevorzugt < 7.0 x 10⁻⁴ m, besonders bevorzugt < 3.0 x 10⁻⁴ m und insbesondere < 0.5 x 10⁻⁴ m. Die erfindungsgemäße Lotmasse enthält bevorzugt Zinn und Wismut, Indium, Zink, Kupfer, Silber oder Zusammensetzungen davon. Der Anteil an Zinn in der erfindungsgemäßen Lotzusammensetzung beträgt von 3 Gew.-% bis 99,5 Gew.-%, bevorzugt von 10 Gew.-% bis 95,5 Gew.-%, besonders bevorzugt von 15 Gew.-% bis 60 Gew.-%. Der Anteil an Wismut, Indium, Zink, Kupfer, Silber oder Zusammensetzungen davon beträgt in der erfindungsgemäßen Lotzusammensetzung von 0,5 Gew.-% bis 97 Gew.-%, bevorzugt 10 Gew.-% bis 67 Gew.-%, wobei der Anteil an Zinn, Wismut, Indium, Zink, Kupfer oder Silber 0 Gew.-% betragen kann. Die erfindungsgemäße Lotzusammensetzung kann Nickel, Germanium, Aluminium oder Phosphor mit einem Anteil von 0 Gew.-% bis 5 Gew.-% enthalten. Die erfindungsgemäße Lotzusammensetzung enthält ganz besonders bevorzugt Bi57Sn42Ag1, Bi59Sn40Ag1, In97Ag3, Sn95,5Ag3,8Cu0,7, Bi67In33, Bi33In50Sn17, Sn77,2In20Ag2,8, Sn95Ag4Cu1, Sn99Cu1, Sn96,5Ag3,5 oder Gemische davon.

Das erfindungsgemäße Anschlusselement enthält bevorzugt zumindest 50 Gew.-% bis 75 Gew.-% Eisen, 25 Gew.-% bis 50 Gew.-% Nickel, 0 Gew.-% bis 20 Gew.-% Kobalt, 0 Gew.-% bis 1,5 Gew.-% Magnesium, 0 Gew.-% bis 1 Gew.-% Silizium, 0 Gew.-% bis 1 Gew.-% Kohlenstoff oder 0 Gew.-% bis 1 Gew.-% Mangan.

Das erfindungsgemäße Anschlusselement enthält bevorzugt Chrom, Niob, Aluminium, Vanadium, Wolfram und Titan mit einem Anteil von 0 Gew.-% bis 1 Gew.-%, Molybdän mit einem Anteil von 0 Gew.-% bis 5 Gew.-% sowie herstellungsbedingte Beimengungen.

Das erfindungsgemäße Anschlusselement enthält bevorzugt zumindest 55 Gew.-% bis 70 Gew.-% Eisen, 30 Gew.-% bis 45 Gew.-% Nickel, 0 Gew.-% bis 5 Gew.-% Kobalt, 0 Gew.-% bis 1 Gew.-% Magnesium, 0 Gew.-% bis 1 Gew.-% Silizium oder 0 Gew.-% bis 1 Gew.-% Kohlenstoff.

Das erfindungsgemäße Anschlusselement enthält weiter bevorzugt zumindest 50 Gew.-% bis 60 Gew.-% Eisen, 25 Gew.-% bis 35 Gew.-% Nickel, 15 Gew.-% bis 20 Gew.-% Kobalt, 0 Gew.-% bis 0,5 Gew.-% Silizium, 0 Gew.-% bis 0,1 Gew.-% Kohlenstoff oder 0 Gew.-% bis 0,5 Gew.-% Mangan.

Das erfindungsgemäße Anschlusselement ist besonders bevorzugt teilweise mit Nickel, Zinn, Kupfer und / oder Silber beschichtet. Das erfindungsgemäße Anschlusselement ist ganz besonders bevorzugt mit 0,1 µm bis 0,3 µm Nickel und / oder 3 µm bis 10 µm Silber beschichtet. Das Anschlusselement kann vernickelt, verzinnt, verkupfert und / oder versilbert werden. Ni und Ag verbessern die Stromtragfähigkeit und Korrosionsstabilität des Anschlusselements und die Benetzung mit der Lotmasse.

Das erfindungsgemäße Anschlusselement enthält bevorzugt Kovar (FeCoNi) und/oder Invar (FeNi) mit einem thermischen Ausdehnungskoeffizienten von Invar von 0,1 x 10⁻⁶/°C bis 4 x 10⁻⁶/°C oder eine maximale Differenz von Kovar von 5 x 10⁻⁶/°C zum Ausdehnungskoeffizienten der Scheibe.

Kovar ist eine Eisen-Nickel-Kobalt Legierung, die Wärmeausdehnungskoeffizienten von üblicherweise etwa 5 x 10⁻⁶/°C aufweist, der damit geringer als der Koeffizient typischer Metalle ist. Die Zusammensetzung enthält beispielsweise 54 Gew.-% Eisen, 29 Gew.-% Nickel und 17 Gew.-% Kobalt. Im Bereich der Mikroelektronik und Mikrosystemtechnik wird deshalb Kovar als Gehäusewerkstoff oder als Submount eingesetzt. Submounts liegen nach dem Sandwichprinzip zwischen dem eigentlichen Trägermaterial und dem Material mit meistens deutlich größerem Ausdehnungskoeffizienten. Kovar dient somit als ausgleichendes Element, welches die durch die unterschiedlichen Wärmeausdehnungskoeffizienten der anderen Materialien verursachten thermomechanischen Spannungen aufnimmt und verringert. In gleicher Weise dient Kovar für Metall-Glas-Durchführungen von elektronischen Bauelementen und Materialübergängen in Vakuumkammern.

Invar ist eine Eisen-Nickel-Legierung mit einem Gehalt von beispielsweise 36 Gew.-% Nickel (FeNi36). Es ist eine Gruppe von Legierungen und Verbindungen, welche die Eigenschaft aufweisen, in bestimmten Temperaturbereichen anomal kleine oder zum Teil negative Wärmeausdehnungskoeffizienten zu haben. Fe65Ni35 Invar enthält 65 Gew.-% Eisen und 35 Gew.-% Nickel. Bis zu 1 Gew.-% Magnesium, Silizium und Kohlenstoff werden üblicherweise legiert, um die mechanischen Eigenschaften zu verändern. Durch Legieren von 5 Gew.-% Kobalt kann der thermische Ausdehnungskoeffizient α weiter reduziert werden. Eine Bezeichnung für die Legierung ist Inovco, FeNi33Co4.5 mit einem Ausdehnungskoeffizienten α (20 °C bis 100 °C) von 0,55 x 10⁻⁶/°C.

Wird eine Legierung wie Invar mit einem sehr geringen absoluten thermischen Ausdehnungskoeffizienten von < 4 x 10⁻⁶/°C verwendet, findet eine Überkompensation der mechanischen Spannungen durch unkritische Druckspannungen im Glas oder durch unkritische Zugspannungen in der Legierung statt.

Das erfindungsgemäße Anschlusselement enthält bevorzugt durch Glühen thermisch nachbehandelte Eisen-Nickel- und/oder Eisen-Nickel-Kobalt-Legierungen.

Kovar und/oder Invar können auch als Ausgleichsplatte auf ein Anschlusselement aus beispielsweise Stahl, Aluminium, Titan, Kupfer angeschweißt, gecrimpt oder geklebt werden. Als Bimetall kann ein günstiges Ausdehnungsverhalten des Anschlusselementes relativ zur Glasausdehnung erzielt werden. Die Ausgleichsplatte ist bevorzugt hutförmig.

Das elektrische Anschlusselement enthält auf der zur Lotmasse ausgerichteten Fläche eine Beschichtung die Kupfer, Zink, Zinn, Silber, Gold oder Kombination davon, bevorzugt Silber enthält. Dadurch wird eine Ausbreitung der Lotmasse über die Beschichtung hinweg verhindert und die Austrittsbreite begrenzt.

Das elektrische Anschlusselement ist über eine Kontaktfläche vollflächig mit einem Teilbereich der elektrisch leitfähigen Struktur verbunden. Des Weiteren weist die Kontaktfläche keine Ecken auf. Die Kontaktfläche kann eine ovale, bevorzugt eine elliptische und insbesondere eine kreisförmige Struktur aufweisen. Alternativ kann die Kontaktfläche eine konvexe polygonale Form, bevorzugt rechteckige Form, mit abgerundeten Ecken aufweisen. Die abgerundeten Ecken weisen einen Krümmungsradius von r > 0.5 mm, bevorzugt von r > 1 mm auf.

Die maximalen Abmessungen der Anschlusselemente sind in der Draufsicht beispielsweise bevorzugt 1 mm bis 50 mm lang und breit und besonders bevorzugt 3 mm bis 30 mm lang und breit und ganz besonders bevorzugt 2 mm bis 4 mm breit und 12 mm bis 24 mm lang.

Die Form des elektrischen Anschlusselementes kann Lotdepots im Zwischenraum von Anschlusselement und elektrisch leitfähiger Struktur ausbilden. Die Lotdepots und Benetzungseigenschaften des Lotes am Anschlusselement verhindern den Austritt der Lotmasse aus dem Zwischenraum. Lotdepots können rechtwinklig, verrundet oder polygonal ausgestaltet sein.

Die Verteilung der Lotwärme und damit die Verteilung der Lotmasse im Lötvorgang kann durch die Form des Anschlusselementes definiert werden. Lotmasse fließt zum wärmsten Punkt. Das Einbringen der Energie beim elektrischen Verbinden von elektrischem Anschlusselement und elektrisch leitfähiger Struktur erfolgt bevorzugt mit Stempellöten, Thermodenlöten, Kolbenlöten, bevorzugt Laserlöten, Heißluftlöten, Induktionslöten, Widerstandslöten und/oder mit Ultraschall.

Die Aufgabe der Erfindung wird weiter durch ein Verfahren zur Herstellung einer Scheibe mit einem Anschlusselement gelöst, wobei
a) Lotmasse auf dem Anschlusselement als Plättchen mit festgelegter Schichtdicke, Volumen, Form und Anordnung angeordnet und aufgebracht wird,
b) eine elektrisch leitfähige Struktur auf einem Substrat aufgebracht wird,
c) das Anschlusselement mit der Lotmasse auf der elektrisch leitfähigen Struktur angeordnet wird und
d) das Anschlusselement mit der elektrisch leitfähigen Struktur verlötet wird.

Die Lotmasse wird bevorzugt vorher auf die Anschlusselemente appliziert, bevorzugt als Plättchen mit festgelegter Schichtdicke, Volumen, Form und Anordnung auf dem Anschlusselement.

Das Anschlusselement wird mit einem teilweise nicht dargestellten Blech, Litze, Geflecht aus beispielsweise Kupfer verschweißt oder gecrimpt und mit der ebenfalls nicht dargestellten Bordelektrik verbunden.

Das Anschlusselement wird bevorzugt in Heizscheiben oder in Scheiben mit Antennen in Gebäuden, insbesondere in Automobilen, Eisenbahnen, Flugzeugen oder Seefahrzeugen benutzt. Das Anschlusselement dient dazu, die leitenden Strukturen der Scheibe mit elektrischen Systemen zu verbinden, welche außerhalb der Scheibe angeordnet sind. Die elektrischen Systeme sind Verstärker, Steuereinheiten oder Spannungsquellen.

Die Erfindung wird anhand einer Zeichnung und Ausführungsbeispielen näher erläutert. Es zeigen:
Fig. 1 eine Draufsicht auf eine erfindungsgemäße Scheibe mit ellipsenförmigem Anschlusselement,
Fig. 2 einen Schnitt A-A' durch die Scheibe gemäß der Figur 1,
Fig. 3 einen Schnitt durch eine alternative erfindungsgemäße Scheibe,
Fig. 4 einen Schnitt durch eine weitere alternative erfindungsgemäße Scheibe,
Fig. 5 eine Draufsicht auf eine alternative Ausführung des Anschlusselements,
Fig. 6 eine Draufsicht auf eine weitere alternative Ausführung des Anschlusselements,
Fig. 7 eine Draufsicht auf eine weitere alternative Ausführung des Anschlusselements,
Fig. 8 eine Seitenansicht des Anschlusselements der Figur 7,
Fig. 9 einen Schnitt durch eine weitere alternative erfindungsgemäße Scheibe mit gewölbtem Anschlusselement,
Fig. 10 ein detailliertes Flussdiagramm des erfindungsgemäßen Verfahrens und
Fig. 11 eine räumliche Darstellung eines brückenförmigen Anschlusselements.

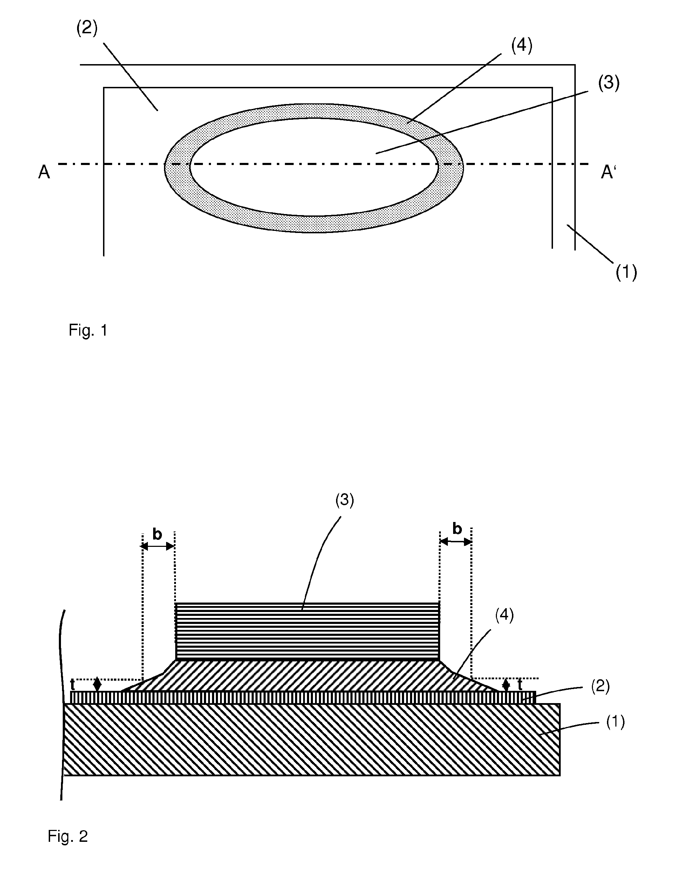

Fig.1 und Fig. 2 zeigen je ein Detail einer erfindungsgemäßen beheizbaren Scheibe 1 im Bereich des elektrischen Anschlusselementes 3. Die Scheibe 1 ist ein 3 mm dickes thermisch vorgespanntes Einscheibensicherheitsglas aus Natron-Kalk-Glas. Die Scheibe 1 weist eine Breite von 150 cm und eine Höhe von 80 cm auf. Auf der Scheibe 1 ist eine elektrisch leitfähige Struktur 2 in Form einer Heizleiterstruktur 2 aufgedruckt. Die elektrisch leitfähige Struktur 2 enthält Silberpartikel und Glasfritten. Im Randbereich der Scheibe 1 ist die elektrisch leitfähige Struktur 2 auf eine Breite von 10 mm verbreitert und bildet eine Kontaktfläche für das elektrische Anschlusselement 3. Im Randbereich der Scheibe 1 befindet sich weiter ein nicht dargestellter Abdecksiebdruck. Im Bereich der Kontaktfläche zwischen dem elektrischen Anschlusselement 3 und der elektrisch leitfähigen Struktur 2 ist eine Lotmasse 4 aufgebracht, die eine dauerhafte elektrische und mechanische Verbindung zwischen dem elektrischen Anschlusselement 3 und der elektrisch leitfähigen Struktur 2 bewirkt. Die Lotmasse 4 enthält 57 Gew.-% Wismut, 42 Gew.-% Zinn und 1 Gew.-% Silber. Die Lotmasse 4 ist durch ein vorgegebenes Volumen und Form vollständig zwischen dem elektrischen Anschlusselement 3 und der elektrisch leitfähigen Struktur 2 angeordnet. Die Lotmasse 4 hat eine Dicke von 250 µm. Ein Austritt der Lotmasse 4 aus dem Zwischenraum zwischen dem elektrischen Anschlusselement 3 und der elektrisch leitfähigen Struktur 2, die eine Schichtdicke t von 50 µm übersteigt, wird auf einer maximalen Austrittsbreite von b = 0,5 mm beobachtet. Das elektrische Anschlusselement 3 ist eine Legierung die 54 Gew.-% Eisen, 29 Gew.-% Nickel und 17 Gew.-% Kobalt enthielt. Das elektrische Anschlusselement 3 ist mit einer ellipsenförmigen Grundfläche ausgestaltet. Die Länge der Hauptachse beträgt 12 mm, die Länge der Nebenachse 5 mm. Die Materialdicke des Anschlusselementes 3 beträgt 0,8 mm. Durch die Anordnung der Lotmasse 4, vorgegeben durch das Anschlusselement 3 und die elektrisch leitfähige Struktur 2, werden keine kritischen mechanischen Spannungen in der Scheibe 1 beobachtet. Die Verbindung der Scheibe 1 mit dem elektrischen Anschlusselement 3 ist über die elektrisch leitfähige Struktur 2 dauerhaft stabil.

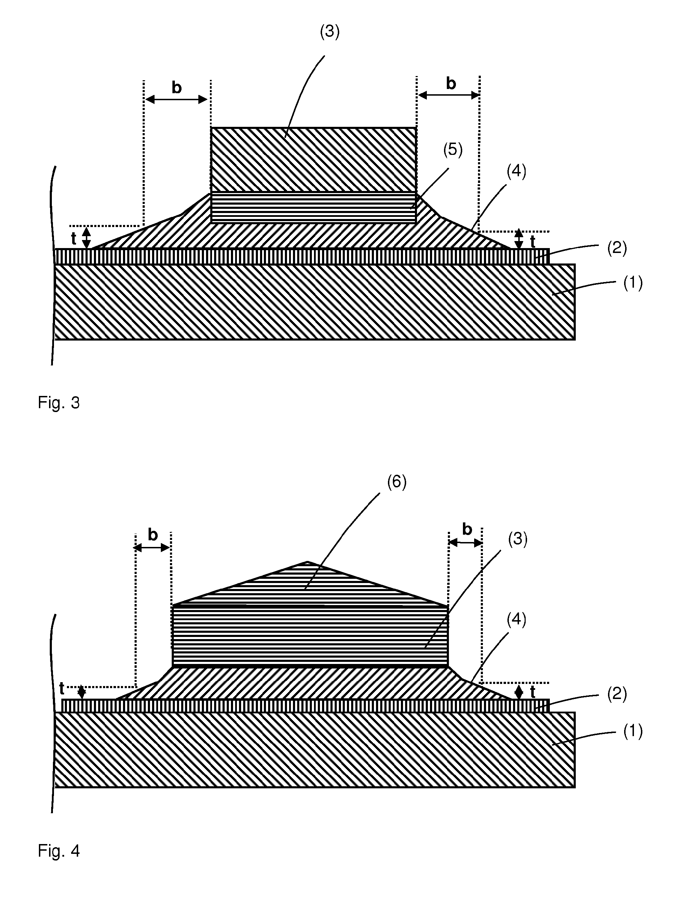

Fig. 3 zeigt in Fortführung des Ausführungsbeispiels der Figuren 1 und 2 eine alternative Ausgestaltung des erfindungsgemäßen Anschlusselementes 3. Das elektrische Anschlusselement 3 ist auf der zur Lotmasse 4 hin ausgerichteten Fläche mit einer silberhaltigen Beschichtung 5 versehen. Dadurch wird eine Ausbreitung der Lotmasse über die Beschichtung 5 hinweg verhindert und die Austrittsbreite b begrenzt. Die Austrittsbreite b der Lotmasse 4 ist unterhalb von 1 mm. Aufgrund der Anordnung der Lotmasse 4 werden keine kritischen mechanischen Spannungen in der Scheibe 1 beobachtet. Die Verbindung der Scheibe 1 mit dem elektrischen Anschlusselement 3 ist über die elektrisch leitfähige Struktur 2 dauerhaft stabil.

Fig. 4 zeigt eine weitere Ausgestaltung der erfindungsgemäßen Scheibe 1 mit einem Anschlusselement 3 mit ellipsenförmiger Grundfläche. Das Anschlusselement 3 enthält eine eisenhaltige Legierung mit einem thermischen Ausdehnungskoeffizienten von 8 x 10⁻⁶/°C. Die Materialdicke beträgt 2 mm. Im Bereich der Kontaktfläche des Anschlusselementes 3 mit der Scheibe 1 ist ein hutförmiger Ausgleichskörper 6 mit einer

Eisen Nickel Kobalt Legierung aufgebracht. Die maximale Schichtdicke des hutförmigen Ausgleichskörpers 6 beträgt 4 mm. Durch den Ausgleichskörper können die thermischen Ausdehnungskoeffizienten des Anschlusselementes 3 den Erfordernissen der Scheibe 1 und der Lotmasse 4 angepasst werden. Der hutförmige Ausgleichskörper 6 führt zu einem verbesserten Wärmefluss während der Herstellung der Lotverbindung 4. Die Erwärmung erfolgt vor allem im Zentrum der Kontaktfläche. Die Austrittsbreite b der Lotmasse 4 kann weiter reduziert werden. Aufgrund der geringen Austrittsbreite b von < 1 mm und des angepassten Ausdehnungskoeffizienten können die thermischen Spannungen in der Scheibe 1 weiter reduziert werden. Die thermischen Spannungen in der Scheibe 1 sind unkritisch und es wird eine dauerhafte elektrische und mechanische Verbindung zwischen dem Anschlusselement 3 und der Scheibe 1 über die elektrisch leitfähige Struktur 2 bereitgestellt.

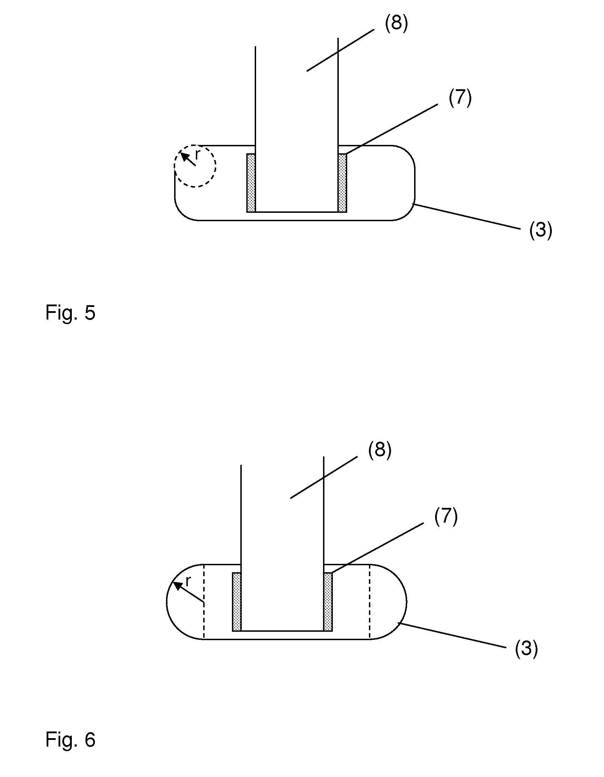

Fig. 5 zeigt eine Draufsicht auf eine alternative Ausführung des erfindungsgemäßen Anschlusselements 3. Das Anschlusselement 3 ist rechteckförmig ausgestaltet und hat eine Breite von 5 mm und eine Länge von 14 mm. Die Ecken des Rechtecks sind jeweils mit einem Kreissegment mit Krümmungsradius r von beispielsweise 1 mm abgerundet. Außerdem ist ein Anschlusskabel 8 über einen Verschweißungsbereich 7 mit dem Anschlusselement 3 verschweißt. Der Verschweißungsbereich 7 hat eine Breite von 3 mm und eine Länge von 6 mm. Das Anschlusskabel 8 ist ein Gewebekabel aus dünnen, verzinnten Kupferdrähten. Es können aber auch Litzenkabel oder Drähte als Anschlusskabel 8 verwendet werden. Alternativ können auch metallische Hülsen, Steckerverbinder oder Crimpanschlüsse mit dem Anschlusselement 3 elektrisch leitend verbunden werden. Insbesondere kann das Anschlusselement 3 auch als ein- oder mehrteilige Klemmhülse oder Crimpelement ausgestaltet sein.

Fig. 6 zeigt eine Draufsicht auf eine weitere Ausführungsform des erfindungsgemäßen Anschlusselements 3. Das Anschlusselement 3 ist rechteckförmig gestaltet, wobei die beiden kurzen Seiten des Rechtecks halbkreisförmig ausgestaltet sind. Das Anschlusselement hat eine Breite von 5 mm und eine Länge von 14 mm. Der Verschweißungsbereich 7 hat eine Breite von 3 mm und eine Länge von 6 mm.

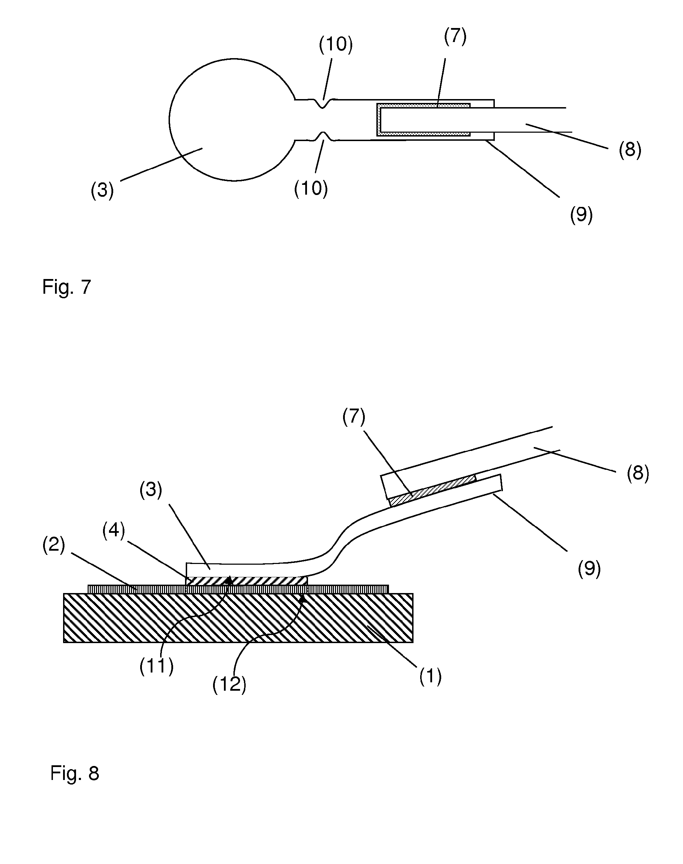

Fig. 7 und Fig. 8 zeigen eine weitere Ausgestaltung des erfindungsgemäßen Anschlusselements 3 mit einer Anschlussfahne 9. Die Kontaktfläche 11 des Anschlusselements 3 ist kreisförmig ausgebildet. Der Radius des Kreises beträgt 4 mm. Die Anschlussfahne 9 ist über einen Verschweißungsbereich 7 mit einem Anschlusskabel 8 verbunden. Alternativ kann die Anschlussfahne 9 auch als Flachstecker sowie als Klemmhülse oder Crimpanschluss ausgestaltet sein. Die Anschlussfahne 9 weist in dieser Ausführung zwei Einkerbungen 10, 10' auf. Diese Einkerbungen 10, 10' dienen zur Reduktion des Material der Anschlussfahne 9. Dies führt zu einer Federwirkung und damit zur Abfederung von Kräften, die über das Anschlusskabel 8 auf den Lötkontakt weitergeleitet werden.

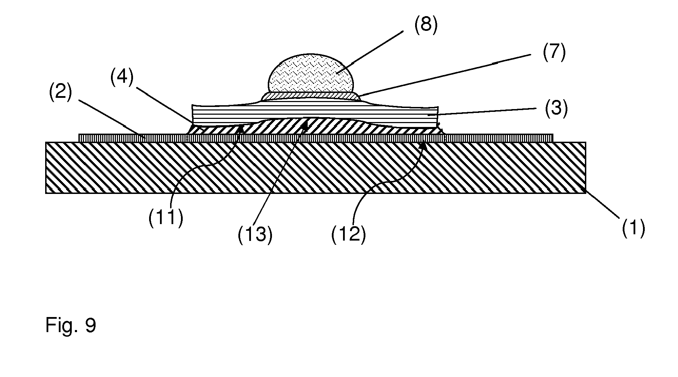

Fig. 9 zeigt einen Schnitt durch eine weitere Ausgestaltung eines erfindungsgemäßen Anschlusselements (3). Das Anschlusselement (3) weist in der Mitte eine Wölbung (13) auf. Im Bereich der Wölbung (13) ist die Lotmasse (4) verdickt.

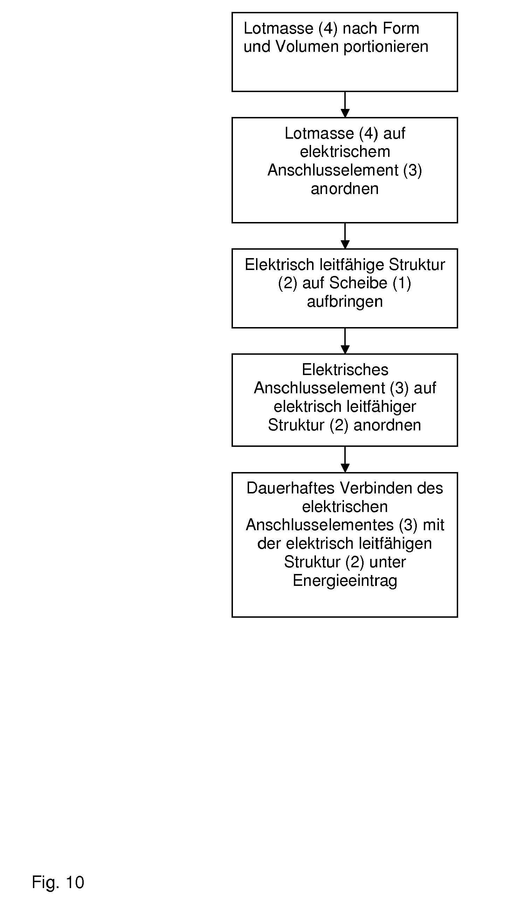

Fig. 10 zeigt detailliert ein Beispiel für das erfindungsgemäße Verfahren zur Herstellung einer Scheibe mit einem elektrischen Anschlusselement 3. Als erster Schritt ist es notwendig die Lotmasse 4 nach Form und Volumen zu portionieren. Die portionierte Lotmasse 4 wird auf dem elektrischen Anschlusselement 3 angeordnet. Das elektrische Anschlusselement 3 wird mit der Lotmasse 4 auf der elektrisch leitfähigen Struktur 2 angeordnet. Es erfolgt eine dauerhafte Verbindung des elektrischen Anschlusselementes 3 mit der elektrisch leitfähigen Struktur 2 und dadurch mit der Scheibe 1 unter Energieeintrag.

### Beispiel:

Testproben wurden angefertigt mit der Scheibe 1 (Dicke 3 mm, Breite 150 cm und Höhe 80 cm), mit der elektrisch leitfähigen Struktur 2 in Form einer Heizleiterstruktur, dem elektrischen Anschlusselement 3, der Silberschicht auf den Kontaktflächen des Anschlusselements 3 und der Lotmasse 4. Die Lotmasse 4 wurde vorher als Plättchen mit festgelegter Schichtdicke, Volumen und Form auf der Kontaktfläche 11 des Anschlusselements 3 aufgebracht. Das Anschlusselement 3 wurde mit der angebrachten Lotmasse 4 auf der elektrisch leitfähigen Struktur 2 angebracht. Das Anschlusselement wurde bei einer Temperatur von 200 °C und einer Behandlungsdauer von 2 Sekunden auf der elektrisch leitfähigen Struktur 2 angelötet. Ein Austritt der Lotmasse 4 aus dem Zwischenraum zwischen dem elektrischen Anschlusselement 3 und der elektrisch leitfähigen Struktur 2, die eine Schichtdicke t von 50 µm überstieg, wurde nur auf einer maximalen Austrittsbreite von b = 0,5 mm beobachtet. Die Ausmaße und Zusammensetzungen der elektrisch leitfähigen Struktur 2, dem elektrischen Anschlusselement 3, der Silberschicht auf den Kontaktflächen des Anschlusselements 3 und der Lotmasse 4 gehen aus der Tabelle 1 und den Figuren 1 und 2 und der Figurenbeschreibung hervor.

Bei sämtlichen Proben konnte bei einem Temperaturunterschied von +80 °C auf -30 °C beobachtet werden, dass kein Glassubstrat 1 brach oder Schäden aufwies. Es konnte gezeigt werden, dass kurz nach dem Anlöten diese Scheiben 1 mit angelötetem Anschlusselement 3 gegen plötzlichen Temperaturabfall stabil waren.

Des Weiteren wurden Testproben mit einer zweiten Zusammensetzung des elektrischen Anschlusselements 3 durchgeführt. Die Ausmaße und Zusammensetzungen der elektrisch leitfähigen Struktur 2, dem elektrischen Anschlusselement 3, der Silberschicht auf den Kontaktflächen des Anschlusselements 3 und der Lotmasse 4 detaillierten Werte gehen aus Tabelle 2 hervor. Auch hier konnte beobachtet werden, dass bei einem Temperaturunterschied von +80 °C auf -30 °C kein Glassubstrat 1 brach oder Schäden aufwies. Es konnte gezeigt werden, dass kurz nach dem Anlöten diese Scheiben 1 mit angelötetem Anschlusselement 3 gegen plötzlichen Temperaturabfall stabil waren.

**Tabelle 1**

| Bestandteile | Material | Beispiel |
|---|---|---|
| Anschlusselement | | |
| | Eisen | 54 |
| | Nickel | 29 |
| | Kobalt | 17 |
| | CTE (coefficient of thermal expansion) x 10⁻⁶ (0 °C - 100 °C) | 5,1 |
| | Differenz zwischen CTE Anschlusselement und Substrat x 10⁻⁶/°C (0 °C - 100 °C) | 3,2 |
| | Dicke des Anschlusselements (m) | 8,0 x 10⁻⁴ |
| Lötbare Schicht | | |
| | Silber | 100 |
| | Dicke der Schicht (m) | 7,0 x 10⁻⁶ |
| Lotschicht | | |
| | Zinn | 42 |
| | Wismut | 57 |
| | Silber | 1 |
| | Dicke der Lotschicht in (m) | 250 x 10⁻⁶ |
| | Die Dicke der lötbaren Schicht und der Lotschicht (m) | 255 x 10⁻⁶ |
| Glas Substrat | | |
| (Natron-Kalk-Glas) | | |
| | CTE x 10⁻⁶ (0 °C - 320 °C) | 8,3 |

**Tabelle 2**

| Bestandteile | Material | Beispiel |
|---|---|---|
| Anschlusselement | | |
| | Eisen | 65 |
| | Nickel | 35 |
| | CTE (coefficient of thermal expansion) x 10⁻⁶ (0 °C - 100 °C) | 1,7 |
| | Differenz zwischen CTE Anschlusselement und Substrat x 10⁻⁶/°C (0 °C - 100 °C) | 6,6 |
| | Dicke des Anschlusselements (m) | 8,0 x 10⁻⁴ |
| Lötbare Schicht | | |
| | Silber | 100 |
| | Dicke der Schicht (m) | 7,0 x 10⁻⁶ |
| Lotschicht | | |
| | Zinn | 42 |
| | Wismut | 57 |
| | Silber | 1 |
| | Dicke der Lotschicht in (m) | 250 x 10⁻⁶ |
| | Die Dicke der lötbaren Schicht und der Lotschicht (m) | 255 x 10⁻⁶ |
| Glas Substrat | | |
| (Natron-Kalk-Glas) | | |
| | CTE x 10⁻⁶ (0 °C - 320 °C) | 8,3 |

### Vergleichsbeispiel 1:

Das Vergleichsbeispiel 1 wurde genauso durchgeführt wie das Beispiel, mit den folgenden Unterschieden: Die Ausmaße und Bestandteile der elektrisch leitfähigen Struktur 2, dem elektrischen Anschlusselement 3, der Metallschicht auf den Kontaktflächen des Anschlusselements 3 und der Lotmasse 4 gehen aus der Tabelle 3 hervor. Die Lotmasse 4 wurde nach dem Stand der Technik nicht vorher als Plättchen auf der Kontaktfläche des Anschlusselements 3 angebracht. Das Anschlusselement 3 wurde mit der elektrisch leitfähigen Struktur 2 nach dem herkömmlichen Verfahren verlötet. Beim Austritt der Lotmasse 4 aus dem Zwischenraum zwischen dem elektrischen Anschlusselement 3 und der elektrisch leitfähigen Struktur 2, die eine Schichtdicke t von 50 µm überstieg, wurde eine durchschnittliche Austrittsbreite b = 2 mm bis 3 mm erhalten.

Bei einem plötzlichen Temperaturunterschied von +80 °C auf -30 °C wurde beobachtet, dass die Glassubstrate 1 kurz nach dem Anlöten überwiegend Schäden aufwiesen.

**Tabelle 3**

| Bestandteile | Material | Vergleichs-Beispiel 1 |
|---|---|---|
| Anschlusselement | | |
| | Titan | 100 |
| | CTE (coefficient of thermal expansion) x 10⁻⁶ (0 °C - 100 °C) | 8,80 |
| | Differenz zwischen CTE des Anschlusselements und des Substrats x 10⁻⁶/°C (0 °C - 100 °C) | 0,5 |
| | Dicke des Anschlusselements (m) | 8,0 x 10⁻⁴ |
| Lötbare Schicht | | |
| | Silber | 100 |
| | Dicke der Schicht (m) | 7,0 x 10⁻⁶ |
| Lotschicht | | |
| | Zinn | 48 |
| | Wismut | 46 |
| | Silber | 2 |
| | Kupfer | 4 |
| | Dicke der Lotschicht in (m) | 50-200 x 10⁻⁶ |
| | Die Dicke der lötbaren Schicht und der Lotschicht (m) | 55-205 x 10⁻⁶ |
| Glas Substrat | | |
| (Natron-Kalk-Glas) | | |
| | CTE x 10⁻⁶ (0 °C - 320 °C) | 8,3 |

### Vergleichsbeispiel 2:

Das Vergleichsbeispiel 2 wurde genauso durchgeführt wie das Beispiel mit den folgenden Unterschieden. Die Ausmaße und Bestandteile der elektrisch leitfähigen Struktur 2, dem elektrischen Anschlusselement 3, der Metallschicht auf den Kontaktflächen des Anschlusselements 3 und der Lotmasse 4 gehen aus der Tabelle 4 hervor. Die Lotmasse 4 wurde nach dem Stand der Technik nicht vorher als Plättchen auf der Kontaktfläche des Anschlusselements 3 angebracht. Das Anschlusselement 3 wurde mit der elektrisch leitfähigen Struktur 2 nach dem herkömmlichen Verfahren verlötet. Beim Austritt der Lotmasse 4 aus dem Zwischenraum zwischen dem elektrischen Anschlusselement 3 und der elektrisch leitfähigen Struktur 2, die eine Schichtdicke t von 50 µm überstieg, wurde eine durchschnittliche Austrittsbreite b = 1 mm bis 1,5 mm erhalten.

Bei einem plötzlichen Temperaturunterschied von +80 °C auf -30 °C wurde beobachtet, dass die Glassubstrate 1 kurz nach dem Anlöten überwiegend Schäden aufwiesen.

**Tabelle 4**

| Bestandteile | Material | Vergleichs-Beispiel 2 |
|---|---|---|
| Anschlusselement | | |
| | Kupfer | 100 |
| | CTE (coefficient of thermal expansion) x 10⁻⁶ (0 °C - 100 °C) | 16 |
| | Differenz zwischen CTE des Anschlusselements und des Substrats x 10⁻⁶/°C (0 °C - 100 °C) | 7,7 |
| | Dicke des Anschlusselements (m) | 8,0 x 10⁻⁴ |
| Lötbare Schicht | | |
| | Silber | 100 |
| | Dicke der Schicht (m) | 7,0 x 10⁻⁶ |
| Lotschicht | | |
| | Zinn | 71,5 |
| | Indium | 24 |
| | Silber | 2,5 |
| | Wismut | 1,5 |
| | Kupfer | 0,5 |
| | Dicke der Lotschicht in (m) | 50-200 x 10⁻⁶ |
| | Die Dicke der lötbaren Schicht und der Lotschicht (m) | 55-205 x 10⁻⁶ |
| Glas Substrat | | |
| (Natron-Kalk-Glas) | | |
| | CTE x 10⁻⁶ (0 °C - 320 °C) | 8,3 |

In der Regel führen höhere Zugspannungen im Glas zu einem erhöhten Risiko von Abplatzern oder Ausmuschelungen im Glas. Deshalb wurde der Einfluss der Kontaktfläche 11 zwischen dem Anschlusselement 3 und dem Teilbereich 12 der elektrisch leitfähigen Struktur 2 durch Computersimulationen untersucht. Dabei wurden die Zugspannungen beim Abkühlen von Scheiben mit Anschlusselementen unterschiedlicher Geometrien berechnet. Die verschiedenen Anschlusselemente waren brückenförmig (B) und kreisförmig (K).

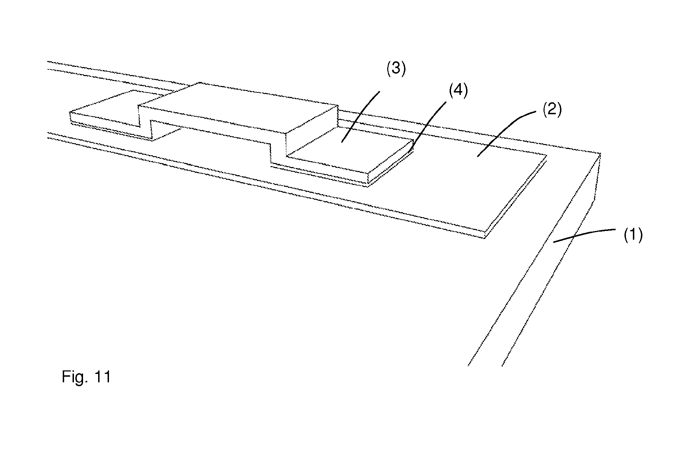

Fig. 11 zeigt eine perspektivische Darstellung des brückenförmigen Anschlusselements 3 (B). Das brückenförmige Anschlusselement (B) hatte eine Breite von 4 mm und eine Länge von 24 mm. Die Kontaktflächen 11 des brückenförmigen Anschlusselements 3 (B) wiesen jeweils eine Breite von 4 mm und eine Länge von 6 mm auf. Das kreisförmige Anschlusselement (K) hatte einen Radius von 4 mm.

Als Material für die Anschlusselemente wurde eine Kovar-Legierung mit einem thermischen Ausdehnungskoeffizienten α von 5,2 x 10⁻⁶/°C und eine Invar-Legierung mit 1,7 x 10⁻⁶/°C angenommen. Die Materialdicke der Anschlusselemente betrug jeweils 0,8 mm. Als Substrat wurde eine Glasscheibe mit einer Materialdicke von jeweils 2 mm angenommen. Die Materialdicke der Lötschicht 4 betrug jeweils 10 µm.

In der Computersimulation wurden die Zugspannungen in der Glasscheibe bei einem Abkühlen von +20 °C auf - 40 °C berechnet. Die maximalen berechneten Zugspannungen sind in Tabelle 4 aufgelistet.

**Tabelle 4**

| Form des Anschlusselements | Maximal Zugsspannung bei -40 °C (MPa) | |
|---|---|---|
| | Kovar | Invar |
| | (mit α = 5,2 x 10-⁶/°C) | (mit α = 1,7 x 10⁻⁶/°C) |
| brückenförmig (B) | 23,8 | 44,9 |
| kreisförmig (K) | 12,8 | 24,3 |

Die maximalen Zugspannungen hingen stark von der Form des Anschlusselements ab. So waren die maximalen Zugspannungen in der Glasscheibe bei kreisförmigen Anschlusselementen (K) aus Kovar oder Invar jeweils um 46 % kleiner als bei brückenförmigen Anschlusselementen (B) aus Kovar oder Invar, siehe Tabelle 4.

Es hat sich gezeigt, dass erfindungsgemäße Scheiben mit Glassubstraten 1 und erfindungsgemäßen elektrischen Anschlusselementen 3 eine bessere Stabilität gegen plötzliche Temperaturunterschiede aufwiesen.

Dieses Ergebnis war für den Fachmann unerwartet und überraschend.

### Bezugszeichenliste

(1) Scheibe / Glas
(2) Elektrisch leitfähige Struktur / Ag-Siebdruck
(3) Elektrisches Anschlusselement / Fe-Ni Legierung Kovar
(4) Lotmasse (Bi57Sn42Ag1)
(5) Benetzungsschicht / Ag-Beschichtung
(6) Ausgleichskörper
(7) Verschweißungsbereich
(8) Anschlusskabel
(9) Anschlussfahne
(10) Einkerbung
(11) Kontaktfläche von (2) und (3)
(12) Teilbereich von (2)
(13) Wölbung
   b maximale Austrittsbreite der Lotmasse
   r Krümmungsradius
   t Grenzdicke der Lotmasse
   A-A' Schnittlinie

## Patentansprüche

1. Eine Scheibe mit einem elektrischen Anschlusselement, umfassend:
- ein Substrat aus Glas (1),
- eine elektrisch leitfähige Struktur (2) mit einer Schichtdicke von 5 µm bis 40 µm auf einem Bereich des Substrats (1),
- ein Anschlusselement (3) und
- eine Schicht einer Lotmasse (4), die das Anschlusselement (3) mit einem Teilbereich (12) der elektrisch leitfähigen Struktur (2) elektrisch verbindet, wobei
- das Anschlusselement (3) zumindest eine Eisen-Nickel-Legierung oder eine Eisen-Nickel-Kobalt-Legierung enthält,
- das Anschlusselement (3) über eine Kontaktfläche (11) vollflächig mit dem Teilbereich (12) der elektrisch leitfähigen Struktur (2) verbunden ist und
- die Kontaktfläche (11) keine Ecken aufweist.

2. Scheibe nach Anspruch 1, wobei das Anschlusselement (3) zumindest 50 Gew.-% bis 75 Gew.-% Eisen, 25 Gew.-% bis 50 Gew.-% Nickel, 0 Gew.-% bis 20 Gew.-% Kobalt, 0 Gew.-% bis 1,5 Gew.-% Magnesium, 0 Gew.-% bis 1 Gew.-% Silizium, 0 Gew.-% bis 1 Gew.-% Kohlenstoff oder 0 Gew.-% bis 1 Gew.-% Mangan enthält.

3. Scheibe nach Anspruch 1 oder 2, wobei die Kontaktfläche (11) eine ovale, bevorzugt eine elliptische und insbesondere eine kreisförmige, Struktur aufweist.

4. Scheibe nach Anspruch 1 oder 2, wobei die Kontaktfläche (11) eine konvexe polygonale Form, bevorzugt eine rechteckige Form, mit abgerundeten Ecken aufweist und die abgerundeten Ecken einen Krümmungsradius von r > 0.5 mm aufweisen.

5. Scheibe nach einem der Ansprüche 1 bis 4, wobei das Anschlusselement (3) zumindest 55 Gew.-% bis 70 Gew.-% Eisen, 30 Gew.-% bis 45 Gew.-% Nickel, 0 Gew.-% bis 5 Gew.-% Kobalt, 0 Gew.-% bis 1 Gew.-% Magnesium, 0 Gew.-% bis 1 Gew.-% Silizium oder 0 Gew.-% bis 1 Gew.-% Kohlenstoff enthält.

6. Scheibe nach Anspruch 5, wobei das Substrat aus Glas (1) einen ersten thermischen Ausdehnungskoeffizienten aufweist, das Anschlusselement (3) einen zweiten thermischen Ausdehnungskoeffizienten aufweist, wobei die Differenz zwischen dem ersten und dem zweiten Ausdehnungskoeffizienten ≥ 5 x 10⁻⁶/°C ist

7. Scheibe nach einem der Ansprüche 1 bis 4, wobei das Anschlusselement (3) zumindest 50 Gew.-% bis 60 Gew.-% Eisen, 25 Gew.-% bis 35 Gew.-% Nickel, 15 Gew.-% bis 20 Gew.-% Kobalt, 0 Gew.-% bis 0,5 Gew.-% Silizium, 0 Gew.-% bis 0,1 Gew.-% Kohlenstoff oder 0 Gew.-% bis 0,5 Gew.-% Mangan enthält.

8. Scheibe nach Anspruch 7, wobei das Substrat aus Glas (1) einen ersten thermischen Ausdehnungskoeffizienten aufweist, das Anschlusselement (3) einen zweiten thermischen Ausdehnungskoeffizienten aufweist und die Differenz zwischen dem ersten und dem zweiten Ausdehnungskoeffizienten < 5 x 10⁻⁶/°C ist.

9. Scheibe nach einem der Ansprüche 1 bis 8, wobei die Lotmasse (4) mit einer Austrittsbreite b von < 1 mm, bevorzugt < 0,5 mm und insbesondere etwa 0 mm, aus dem Zwischenraum zwischen dem Anschlusselement (3) und der elektrisch leitfähigen Struktur (2) austritt.

10. Scheibe nach einem der Ansprüche 1 bis 9, wobei die Lotmasse (4) Zinn und Wismut, Indium, Zink, Kupfer, Silber oder Zusammensetzungen davon enthält.

11. Scheibe nach Anspruch 10, wobei der Anteil an Zinn in der Lotzusammensetzung (4) 3 Gew.-% bis 99,5 Gew.-% beträgt und der Anteil von Wismut, Indium, Zink, Kupfer, Silber oder Zusammensetzungen davon 0,5 Gew.-% bis 97 Gew.-% beträgt.

12. Scheibe nach einem der Ansprüche 1 bis 11, wobei das Anschlusselement (3) mit Nickel, Zinn, Kupfer und / oder Silber beschichtet ist.

13. Scheibe nach Anspruch 12, wobei das Anschlusselement (3) mit 0,1 µm bis 0,3 µm Nickel und / oder 3 µm bis 10 µm Silber beschichtet ist.

14. Verfahren zur Herstellung einer Scheibe mit einem elektrischen Anschlusselement (3), wobei
a) Lotmasse (4) auf dem Anschlusselement (3) als Plättchen mit festgelegter Schichtdicke, Volumen, Form und Anordnung angeordnet und aufgebracht wird,
b) eine elektrisch leitfähige Struktur (2) auf einem Substrat (1) aufgebracht wird,
c) das Anschlusselement (3) mit der Lotmasse (4) auf der elektrisch leitfähigen Struktur (2) angeordnet wird und
d) das Anschlusselement (3) mit der elektrisch leitfähigen Struktur (2) verlötet wird.

15. Verwendung einer Scheibe mit einem elektrischen Anschlusselement nach einem der Ansprüche 1 bis 13 als Fahrzeugscheibe in Fortbewegungsmitteln für den Verkehr auf dem Lande, in der Luft oder zu Wasser, insbesondere in Kraftfahrzeugen beispielsweise als Windschutzscheibe, Heckscheibe, Seitenscheibe und/oder Glasdach.
